Europäisches Patentamt

European Patent Office

Office européen des brevets

(11) Veröffentlichungsnummer: **0 351 581**
**A1**

## EUROPÄISCHE PATENTANMELDUNG

(21) Anmeldenummer: 89111438.1

(22) Anmeldetag: 23.06.89

(51) Int. Cl.⁴: **H01L 23/498 , H01L 21/66**

(30) Priorität: **22.07.88 CH 2797/88**

(43) Veröffentlichungstag der Anmeldung:
**24.01.90 Patentblatt 90/04**

(84) Benannte Vertragsstaaten:
**CH DE FR GB LI SE**

(71) Anmelder: **CONTRAVES AG**
**Schaffhauserstrasse 580**
**CH-8052 Zürich(CH)**

(72) Erfinder: **Ackermann, Karl-Peter, Dr.**
**Gwiggweg 36**
**CH-5443 Niederrohrdorf(CH)**
Erfinder: **Berner, Gianni, Dr.**
**Eichtalhöhe 18**
**CH-5400 Baden(CH)**

(74) Vertreter: **Lück, Gert, Dr. rer. nat. et al**
**c/o ASEA BROWN BOVERI AG**
**Patentabteilung**
**CH-5401 Baden(CH)**

(54) **Hochintegrierte Schaltung sowie Verfahren zu deren Herstellung.**

(57) Bei einer hochintegrierten Schaltung wird der Halbleiterchip (8) auf einem Substrat (17) befestigt, der auf allen Seiten nur wenige Millimeter über den Halbleiterchip (8) hinausragt. Zum vollständigen dynamischen Testen der Schaltung vor dem Einbau sind Anschlüsse vorgesehen, die ausserhalb des überstehenden Substratrands (23) mit einem ausreichend grossen Rastermass angeordnet sind.

In einer ersten Ausführungsform werden "verlorene" Testanschlüsse (5) verwendet, die nach dem Testen abgetrennt werden.

In einer zweiten Ausführungsform werden zum Testen Kontaktflächen in Form von Bumps (21) verwendet, die auf der Unterseite von in der Chip-Montagefläche liegenden Durchkontaktierungs-Bohrungen (18) angeordnet sind.

Auf diese Weise ist eine Schaltung mit stark reduziertem Platzbedarf realisierbar, die gleichwohl vor dem Einbau vollständig dynamisch getestet werden kann.

FIG.2D

FIG.3E

## Hochintegrierte Schaltung sowie Verfahren zu deren Herstellung

Technisches Gebiet

Die vorliegende Erfindung bezieht sich auf das Gebiet der Mikroelektronik. Sie betrifft speziell eine hochintegrierte Schaltung, insbesondere für ein Multi-Chip-Modul, umfassend:

(a) einen flächigen Halbleiterchip mit einer Chip-Fläche und einer Vielzahl von in einem ersten Rastermass angeordneten Chip-Anschlüssen;

(b) ein flächiges Substrat mit einer Oberseite und einer Unterseite und einer Substratfläche, welche grösser ist als die Chip-Fläche;

(c) auf der Oberseite des Substrats eine Montagefläche, auf welcher der Halbleiterchip angeordnet ist; wobei

(d) das Substrat auf allen Seiten mit einem Substratrand über den Halbleiterchip hinausragt; und

(e) auf der Oberseite des Substrats erste Anschlussflächen vorgesehen sind mit einem Rastermass, welches im wesentlichen gleich dem ersten Rastermass ist; und

(f) die Chip-Anschlüsse mit den ersten Anschlussflächen leitend verbunden sind.

Eine solche hochintegrierte Schaltung ist aus der herkömmlichen Gehäusetechnologie bekannt.

Die Erfindung betrifft weiterhin ein Verfahren zur Herstellung einer solchen hochintegrierten Schaltung, bei der auf der Oberseite des Substrats Leiterbahnen von den ersten Anschlussflächen ausgehend zu den Rändern des Substrats verlaufen; und an den Rändern des Substrats zweite Anschlussflächen vorgesehen sind, welche mit den ersten Anschlussflächen durch die Leiterbahnen verbunden sind.

Die Erfindung betrifft schliesslich eine Verfahren zur Herstellung einer solchen hochintegrierten Schaltung, bei der innerhalb der Montagefläche im Substrat durchmetallisierte Durchkontaktierungs-Bohrungen vorgesehen sind, welche die Oberseite des Substrats mit seiner Unterseite leitend verbinden, und auf der Unterseite Kontaktflächen in Form von Bumps aufweisen; die Durchkontaktierungs-Bohrungen in einem Rastermass angeordnet sind, welches wesentlich grösser ist als das erste Rastermass; und zumindest auf der Oberseite des Substrats Leiterbahnen von den ersten Anschlussflächen ausgehend zu den Durchkontaktierungs-Bohrungen verlaufen.

Stand der Technik

Die nach wie vor zunehmende Miniaturisierung und Integration in der Mikroelektronik kommt in den immer komplexer werdenden hochintegrierten VLSI(Very Large Scale Integration)-Schaltungen zum Ausdruck.

Das weitere Vordringen in den Sub-Mikrometer-Bereich bei gleichzeitig höherer Komplexität führt zu Integrierten Schaltungen (IS) mit mehreren Millionen Transistorfunktionen und mit Flächen des Si-Chips von mehr als 12mm x 12mm. Die Anzahl der Anschlüsse pro IS steigt dabei überproportional an (Moore's Gesetz).

Aufgrund dieser Entwicklung ergeben sich vor allem Probleme bei den Gehäusetechnologien für solche IS, d.h. beim Einbau der Chips. Die zur Zeit bekannten und verwendeten Gehäuse wie z.B, DIP, SO, PLCC, LCCC, PGA usw. (siehe dazu: Electronics, November 11 (1985), S.26-31) werden für Anschlusszahlen grösser etwa 200 pro IS unverhältnismässig gross und damit unwirtschaftlich und unzuverlässig, und führen zu erhöhten Verzögerungszeiten der elektrischen Signale von und zur IS.

Die Gründe dafür liegen bei den Anforderungen an die minimalen Abstände der Anschlüsse solcher Gehäuse, die etwa 0.5 mm betragen müssen, um Lötverbindungen zum Trägersubstrat (Leiterplatte oder Keramiksubstrat) zu ermöglichen. Bei 200 Anschlüssen ergeben sich damit Gehäuse-Kantenlängen von mehr als 25 mm, sodass das Verhältnis von aktiver Chip-Fläche zum Flächenbedarf des Gehäuses sehr schlecht wird.

Einen potentiellen Ausweg aus dieser Problematik findet man mit der Montage von nackten IS-Chips (ohne Gehäuse) auf einem grossflächigen Trägersubstrat, wobei die elektrischen Verbindungen von der IS zum Substrat z.B. mittels Flip-Chip oder Wire-Bonding realisiert werden können.

Mit Vorteil werden dabei mehrere IS auf einem solchen Trägersubstrat montiert und elektrisch auf engstem Raum verbunden. Daraus resultieren sog. Multi-Chip-Module (MCM) oder Multi-Chip-Packages (MCP). Man erreicht so eine sehr platzsparende und zuverlässige Montage auch für IS mit mehr als 200 Anschlüssen.

Auch diese Gehäuse- und Montagetechnik hat jedoch ihre Probleme: Die nackten IS können vor ihrer Montage nicht zu 100% dynamisch geprüft und auch nicht einem Burn-in-Test unterzogen werden. Gerade Anwender von modernsten IS sehen sich oft gezwungen, eine schlechte Ausbeute bei den IS akzeptieren zu müssen. Eine schlechte Ausbeute bei den IS hat aber verheerende Auswirkungen auf die Ausbeute bei den MCM. So fällt beispielsweise bei der Montage von 5 IS mit einer Ausbeute von je 90% die Gesamtausbeute des MCM auf Werte kleiner 60% ab. Defekte IS auf solchen MCMs zu ersetzen, ist jedoch nur beschränkt möglich und in jedem Fall sehr aufwendig und teuer.

Eine andere potentielle Lösung der Gehäuse-Probleme bei den IS ist das Tape Automated Bonding (TAB). Diese spezielle Gehäuse-und Montagetechnik auf einem Filmträger erlaubt es, die IS vor dem Einbau vollständig zu prüfen (siehe dazu: Electronic Packaging & Production, December, 1984, S.34-39).

Auch die TAB-Technologie hat jedoch eine Reihe gravierender Nachteile, wie z.B.:
- die insgesamt benötigte Fläche ist immer noch wesentlich grösser als die aktive Fläche des Si-Chips;
- die IS müssen zusätzlich auf dem Wafer einer speziellen Behandlung unterzogen werden (Aufbau von sog. Bumps auf die IS-Anschlüsse in einer Wafer-Fabrikation);
- es sind spezielle, teure Werkzeuge für die Montage erforderlich; und
- die Prüfung und das Handling muss auf speziellen Maschinen erfolgen.

TAB ist deshalb nur für ausgewählte Anwendung geeignet, bei denen es z.B. um hohe Stückzahlen oder eine sehr geringe Bauhöhe geht.


Darstellung der Erfindung

Es ist daher Aufgabe der vorliegenden Erfindung, eine hochintegrierte Schaltung zu schaffen, die vor der Montage vollständig dynamisch prüfbar ist, deren Platzbedarf gegenüber der aktiven Chip-Fläche nur unwesentlich grösser ist, und die ohne spezielle Werkzeuge und Maschinen hergestellt und montiert werden kann, sowie Verfahren zu deren Herstellung anzugeben.

Die Aufgabe wird bei einer hochintegrierten Schaltung der eingangs genannten Art dadurch gelöst, dass der Substratrand eine Randbreite von nur wenigen Millimetern aufweist und Anschlüsse zum Testen des Halbleiterchips ausserhalb des Substratrands vorgesehen sind.

Vorzugsweise wird eine Randbreite von weniger als 2 mm gewählt. Da eine solche Randbreite nicht ausreicht, um Testanschlüsse mit einem ausreichend grossen Rastermass aufzunehmen, werden diese gemäss der Erfindung ausserhalb des Substratrands angeordnet.

Ein erstes bevorzugtes Ausführungsbeispiel der Erfindung zeichnet sich dadurch aus, dass

(a) auf der Oberseite des Substrats Leiterbahnen von den ersten Anschlussflächen ausgehend zu den Rändern des Substrats verlaufen; und

(b) an den Rändern des Substrats zweite Anschlussflächen vorgesehen sind, welche mit den ersten Anschlussflächen durch die Leiterbahnen verbunden sind.

Testanschlüsse sind hierbei an der fertigen Schaltung überhaupt nicht vorgesehen, sondern nur in einem Zwischenstadium der Herstellung vorhanden.

Das erfindungsgemässe Verfahren zur Herstellung einer solchen Schaltung ist durch die folgenden Schritte gekennzeichnet:

(a) auf eine Substratplatte , welche eine Fläche aufweist, die wesentlich grösser ist als die Substratfläche , und welche das spätere Substrat mit der Montagefläche in der Flächenmitte liegend enthält, werden innerhalb der Substratfläche die ersten Anschlussflächen und ausserhalb der Substratfläche mit einem wesentlich grösseren Rastermass Testanschlüsse aufgebracht, sowie Leiterbahnen, welche die ersten Anschlussflächen mit den Testanschlüssen verbinden;

(b) der Halbleiterchip wird innerhalb der Montagefläche auf der Substratplatte befestigt;

(c) die Chip-Anschlüsse werden mit den ersten Anschlussflächen leitend verbunden;

(d) der Halbleiterchip wird mittels der Testanschlüsse in seiner Funktion vollständig durchgetestet; und

(e) das Substrat wird von der Substratplatte abgetrennt wobei die Leiterbahnen an den Rändern des Substrats durchgetrennt werden.

Ein zweites bevorzugtes Ausführungsbeispiel der Erfindung zeichnet sich dadurch aus, dass

(a) innerhalb der Montagefläche im Substrat durchmetallisierte Durchkontaktierungs-Bohrungen vorgesehen sind, welche die Oberseite des Substrats mit seiner Unterseite leitend verbinden, und auf der Unterseite Kontaktflächen in Form von Bumps aufweisen;

(b) die Durchkontaktierungs-Bohrungen in einem Rastermass angeordnet sind, welches wesentlich grösser ist als das erste Rastermass; und

(c) zumindest auf der Oberseite des Substrats Leiterbahnen von den ersten Anschlussflächen ausgehend zu den Durchkontaktierungs-Bohrungen verlaufen.

Bei diesem Ausführungsbeispiel dienen die Bumps auf der Unterseite der Durchkontaktierungs-Bohrungen mit ihrem vergleichsweise grossen Rastermass zugleich zum Testen und zum Anschliessen der Schaltung.

Das erfindungsgemässe Verfahren zur Herstellung einer solchen Schaltung ist durch folgende Schritte gekennzeichnet:

(a) in das Substrat werden innerhalb der Montagefläche die Durchkontaktierungs-Bohrung eingebracht;

(b) auf das Substrat werden die ersten Anschlussflächen aufgebracht, sowie Leiterbahnen, welche die ersten Anschlussflächen mit den Durchkontaktierungs-Bohrungen verbinden;

(c) die Durchkontaktierungs-Bohrungen werden durchmetallisiert und auf der Unterseite mit den Bumps versehen;

(d) der Halbleiterchip wird innerhalb der Montagefläche auf dem Substrat befestigt;

(e) die Chip-Anschlüsse werden mit den ersten Anschlussflächen leitend verbunden; und

(g) der Halbleiterchip wird mittels der Bumps in seiner Funktion vollständig durchgetestet.

Weitere Ausführungsbeispiele ergeben sich aus den Unteransprüchen.

Die vorliegende Erfindung löst somit die oben erwähnten Probleme durch ein neues Gehäuse- und Montagekonzept, welches auch auf komplexe IS mit einer grossen Zahl von Anschlüssen angewendet werden kann. Dieses Konzept eignet sich speziell auch für die Montage mehrerer solcher IS auf einer Schaltungsplatte, d.h. für Multi-Chip-Module.

Die vorliegende Erfindung zeichnet sich durch die folgenden Vorteile aus:
- die IS ist vor der Montage vollständig dynamisch prüfbar (einschliesslich Burn-in-Test);
- der Platzbedarf ist nur unwesentlich grösser als für den Si-Chip selbst; und
- es sind keine Spezialwerkzeuge- und maschinen (mit Ausnahme eines Wire-Bonders) und keine speziellen Fertigungsschritte bei der IS-Herstellung notwendig.

Kurze Beschreibung der Zeichnung

Die Erfindung soll nun nachfolgend anhand von Ausführungsbeispielen im Zusammenhang mit der Zeichnung näher erläutert werden. Es zeigen

Fig.1 eine bekannte Gehäusekonfiguration für eine hochkomplexe IS;

Fig.2A-F verschiedene Schritte bei der Herstellung und Montage einer hochintegrierten Schaltung gemäss einem ersten bevorzugten Ausführungsbeispiel der Erfindung;

Fig.3A-F verschiedene Schritte bei der Herstellung und Montage einer hochintegrierten Schaltung gemäss einem zweiten bevorzugten Ausführungsbeispiel der Erfindung;

Fig.4 eine alternative Verbindungsart (Flip-Chip) zu der in Fig.2B dargestellten; und

Fig.5 eine alternative Verbindungsart (Flip-Chip) zu der in Fig.3D dargestellten.

Wege zur Ausführung der Erfindung

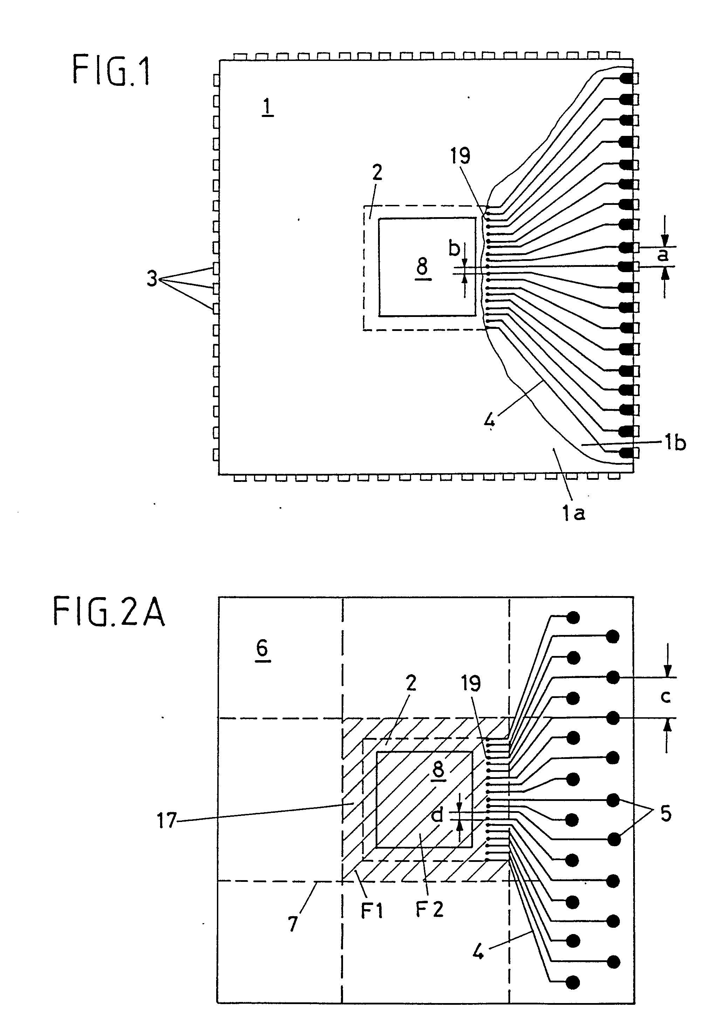

In der Fig. 1 is eine Gehäusekonfiguration für eine hochkomplexe IS nach dem Stand der Technik dargestellt. Sie umfasst eine Gehäuse 1, welches im wesentlichen aus einer oberen Keramikplatte 1a und einer unteren Keramikplatte 1b besteht (die obere Keramikplatte 1a ist in der Darstellung teilweise weggelassen, um die Verbindungsführung erkennbar zu machen).

Auf der unteren Keramikplatte 1b ist in der Mitte der Plattenfläche eine Montagefläche 2 für ein Halbleiterchip 8 (die aktive IS) vorgesehen. Am Rande des Gehäuses 1 sind umlaufend Anschlusskontakte 3 angeordnet mit einem standardisierten Rastermass a, welches beispielsweise 1,27 mm (entsprechend 1/20" oder 50 mil) beträgt. Dieses vergleichsweise grosse Rastermass a ist notwendig, um eine einwandfreie Lötung der Anschlusskontakte beim Einbau der konfigurierten IS zu gewährleisten.

Von den Anschlusskontakten 3 führen auf der unteren Keramikplatte 1b Leiterbahnen 4 zu der Montagefläche 2 und münden dort in kleine erste Anschlussflächen 19, die mit einem Rastermass b entlang dem Umfang der Montagefläche 2 angeordnet sind. Das Rastermass b ist sehr viel kleiner als das Rastermass a und entspricht in etwa dem Rastermass der Chip-Anschlüsse (22 in Fig.2B) auf dem Halbleiterchip 8, die der Uebersichtlichkeit halber in Fig.1 nicht eingezeichnet sind. Chip-Anschlüsse und erste Anschlussflächen 19 sind (ebenfalls nicht dargestellt) üblicherweise mittels Wire-Bonding untereinander leitend verbunden.

Die gesamte Schaltung kann vor dem Einbau über die Anschlusskontakte 3 vollständig dynamisch getestet werden. Dieser Vorteil wird jedoch damit erkauft, dass der Platzbedarf für das Gehäuse 1 um ein Vielfaches grösser ist als die durch den Halbleiterchip 8 vorgegebene Fläche.

Um gleichzeitig die volle dynamische Testbarkeit und einen drastisch reduzierten Platzbedarf zu verwirklichen, geht die Erfindung gemäss einem in den Fig.2A-F dargestellten bevorzugten Ausführungsbeispiel folgenden Weg:

Zunächst wird von einer relativ grossflächigen Substratplatte 6 ausgegangen (Fig.2A). Diese Substratplatte 6 besteht z.B. aus einer üblichen isolierenden Keramik (A1203 o.ä.), aus Silizium, das mit einer Isolierschicht bedeckt ist, oder einem Glas, und hat, wenn beispielweise von 224 Anschlüssen für die IS ausgegangen wird, eine Fläche von z.B. 1" x 1".

In der Substratplatte 6 enthalten ist ein Substrat 17 (in Fig. 2A schraffiert eingezeichnet) mit einer Substratfläche F1, die wesentlich kleiner ist als die Fläche der Substratplatte 6, und nur wenig (auf allen Seiten etwa 1-2 mm) grösser ist als der Halbleiterchip 8 mit einer Chip-Fläche F2. Die Substratfläche F1 wird innerhalb der Substratplatte 6 durch Trennlinien 7 festgelegt, entlang derer zu einem späteren Zeitpunkt (nach dem Testen) das Substrat 17 von der Substratplatte 6 abgetrennt wird.

Auf die Substratplatte 6 werden Leiterbahnen 4 aufgebracht, die auf der einen Seite in die ersten Anschlussflächen 19 und auf der anderen Seite in Testanschlüsse 5 münden. Die ersten Anschlussflächen 19 liegen dabei innerhalb der Substratfläche F1 entlang dem Umfang der Montagefläche 2, die Testanschlüsse 5 ausserhalb dieser Substratfläche am Rande der Substratplatte 6.

Während die ersten Anschlussflächen 19 auch hier ein Rastermass d aufweisen, das in etwa dem Rastermass der Chip-Anschlüsse entspricht, können die Testanschlüsse 5 mit einem Rastermass c von z.B. 1,27 mm ausgeführt werden, sodass die Schaltung in diesem Zustand in einer üblichen Testvorrichtung vollständig getestet werden kann.

Die ersten Anschlussflächen 19, Leiterbahnen 4 und Testanschlüsse 5 werden vorzugsweise durch chemische Abscheidung mehrerer Metallschichten, insbesondere von Cu, Ni und Au, auf die Substratplatte 6 aufgebracht (in Fig.2A der Uebersichtlichkeit halber nur für eine Plattenseite dargestellt).

Nachdem die Substratplatte 6 auf diese Weise mit den Leitungsmustern versehen worden ist, wird der Halbleiterchip 8 innerhalb der Montagefläche 2 auf der Substratplatte 6 befestigt, und die Chip-Anschlüsse 22 werden mit den ersten Anschlussflächen 19 leitend verbunden (Fig.2B).

In der Schnittdarstellung der Fig.2B wird für das Verbinden die Technik des Wire-Bonding angewandt, bei der Anschlussdrähte 9, die auf die ersten Anschlussflächen 19 und die Chip-Anschlüsse 22 gebonded sind, verwendet werden.

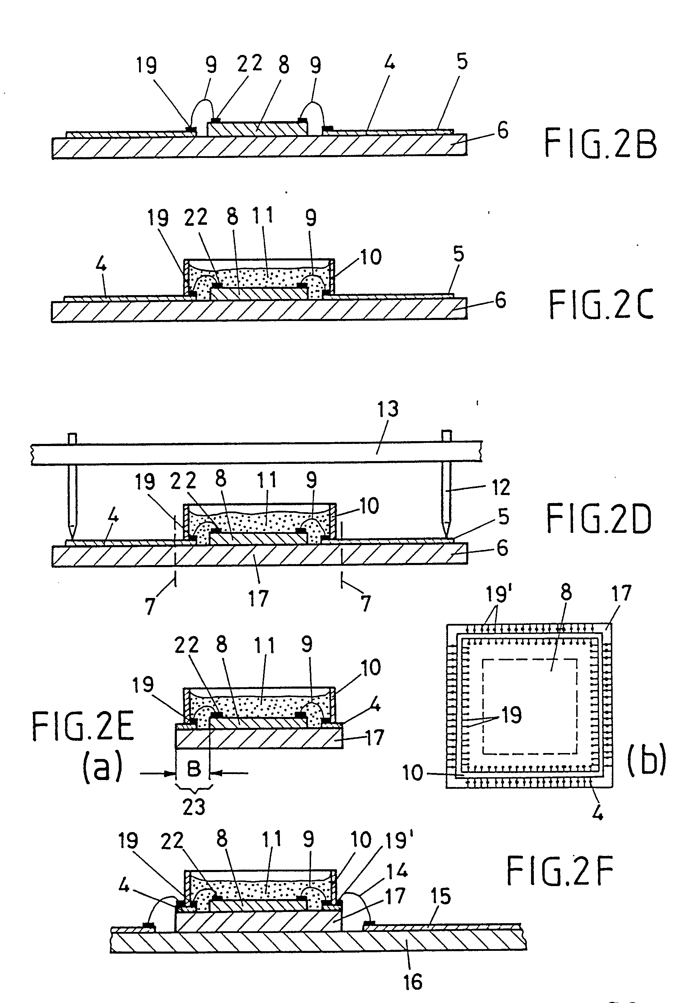

Eine dazu alternative Verbindungstechnik, die unter der Bezeichnung "Flip-Chip" bekannt ist, ist in der Fig.4 wiedergegeben. Dort sind die ersten Anschlussflächen 19 innerhalb der Montagefläche 2 spiegelbildlich zu den Chip-Anschlüssen 22 angeordnet, und der Halbleiterchip 8 wird umgekehrt mit den ersten Anschlussflächen 19 direkt verlötet.

Nachdem die mechanische und elektrische Montage des Halbleiterchips 8 auf der Substratplatte 6 abgeschlossen ist, wird der Halbleiterchip 8 zum Schutz mit einer Vergussmasse 11 (z.B. einer Epoxy- oder Silikonmasse) abgedeckt (Fig.2C) und zwar derart, dass die Leiterbahnen 4 an den Rändern des späteren Substrats 17 zu Anschlusszwecken freiligen. Eine entsprechende Begrenzung der Vergussmasse 11 wird im Beispiel der Fig.2C durch einen entsprechend grossen Rahmen 10 erreicht, der als eine Art Gussform dient.

Das Vergiessen dient dabei dem Schutz des Halbleiterchips 8 und insbesondere der Anschlussdrähte 9. Bei der alternativen Flip-Chip-Verbindungstechnik gemäss Fig.4 ist die Verwendung der Vergussmasse 11 nicht notwendig.

Die so geschützte Schaltung wird dann in einer üblichen Testvorrichtung, die in einer Testhalterung 13 gelagerte Testspitzen 12 mit entsprechendem Rastermass aufweist, vollständig dynamisch getestet (Fig.2D) und ggf. einem Burn-in-Test unterzogen.

Ist der dynamische Test (und der Burn-in-Test) erfolgreich verlaufen, wird das Substrat 17 mit dem vergossenen Halbleiterchip 8 und den an den Rändern des Substrats 17 freiliegenden Leiterbahnen 4 entlang der Trennlinien 7 von der Substratplatte 6 abgetrennt. Sofern die Substratplatte 6 aus einer Keramik oder einem Glas besteht, kann dieser Trennvorgang durch Ritzen und anschliessendes Brechen erfolgen. Gleichermassen ist jedoch auch ein Säge- oder Schneidvorgang denkbar. Die Leiterbahnen 4 werden dabei an den Rändern des Substrats 17 durchgetrennt.

Es resultiert eine hochintegrierte Schaltung, wie sie in Fig. 2E(a) im Schnitt und in Fig.2E(b) in der Draufsicht dargestellt ist. Sie zeichnet sich dadurch aus, dass das Substrat 17 auf allen Seiten mit einem Substratrand 23 über den Halbleiterchip 8 hinausragt, der eine Randbreite B von nur wenigen Millimetern aufweist, und dass auf dem Substrarand keine Anschlüsse zum Testen der Schaltung mehr vorgesehen sind.

Die fertige und durchgetestete Schaltung kann dann z.B. in ein Multi-Chip-Modul eingebaut werden, wobei die Schaltung auf einer grösseren Schaltungsplatte 16 befestigt mittels Wire-Bonding durch Anschlussdrähte 14 mit Leiterbahnen 15 auf der Schaltungsplatte 16 elektrisch verbunden wird (Fig.2F). Auf der Seite der IS erfolgt der Anschluss dabei an zwiten Anschlussflächen 19', die an den auf einer Länge von nur wenigen 100 $\mu$m freiliegenden Enden der Leiterbahnen 4 angeordnet sind.

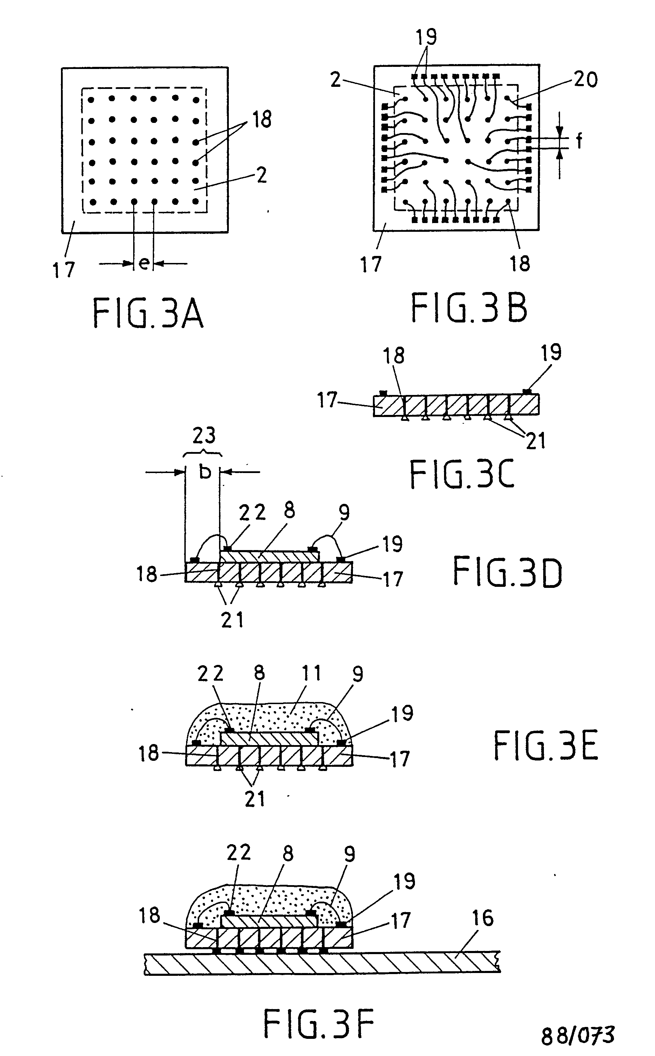

Eine zum eben beschriebenen Prinzip der "verlorenen" Testanschlüsse gleichwertige Lösung soll an dem in Fig.3A-F dargestellten Ausführungsbeispiel erläutert werden.

Hierbei werden zum Testen dieselben Anschlüsse benutzt, die auch zum Verbinden der IS mit einer grösseren Schaltungsplatte dienen. Diese Anschlüsse liegen auch in diesem Fall ausserhalb des Substratrandes, und zwar innerhalb der Montagefläche direkt unter dem Halbleiterchip.

Ausgegangen wird hier nicht von einer grösseren Substratplatte, sondern direkt von dem Substrat 17 in seiner endgültigen Grösse. In das Substrat 17, welches aus demselben Material bestehen kann wie die Substratplatte 6, werden innerhalb der Montagefläche 2 eine Vielzahl von Durchkontaktierungs-Bohrungen 18 eingebracht mit einem Rastermass e, welches wesentlich grösser ist als das Rastermass der Chip-Anschlüsse und vorzugsweise 1,27 mm beträgt (Fig.3A). Die Durchkontaktierungs-Bohrungen 18, die von der Oberseite des Substrats 17 zu dessen Unterseite verlaufen, dienen später der leitenden Verbindung von Ober- und Unterseite. Sie können beispielsweise in einem Keramiksubstrat mittels eines Lasers hergestellt werden.

Auf das gebohrte Substrat 17 werden dann (z.B. mit den bereits erwähnten Verfahren) die ersten Anschlussflächen 19 und Leiterbahnen 20 aufgebracht, welche die ersten Anschlussflächen 19 mit den Durchkontaktierungs-Bohrungen 18 verbinden (Fig.3B). Die Leiterbahnen 20 können dabei sowohl auf der Ober- als auch auf der Unterseite des Substrats 17 angeordnet werden. Die ersten Anschlussflächen 19 weisen ein Rastermass f auf, das ebenfalls in etwa gleich dem Rastermass der Chip-Anschlüsse ist.

Zusätzlich bzw. gleichzeitig zum Aufbringen der Leiter- und Anschluss-Strukturen werden die Durchkontaktierungs-Bohrungen 18 durchmetallisiert und auf der Unterseite des Substrats 17 (vorzugsweise durch elektrochemische Abscheidung) mit Kontaktflächen in Form von sog.Bumps 21 versehen. Es ergibt sich ein Substrat, wie es in Fig.3C im Schnitt dargestellt ist. Die Leiterbahnen 20 sind in dieser Darstellung der Einfachheit halber nicht eingezeichnet.

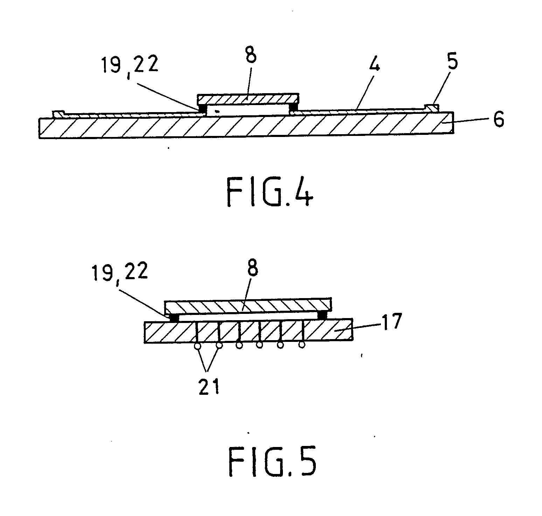

Auf dem so vorbereiteten Substrat 17 wird nun der Halbleiterchip 8 befestigt und mit dem Substrat 17 elektrisch verbunden. Dies geschieht wiederum entweder durch Wire-Bonding (Fig.3D: Anschlussdrähte 9 von den Chip-Anschlüssen 22 zu den ersten Anschlussflächen 19) oder durch Flip-Chip-Montage (Fig.5).

An dieser Stelle sei darauf hingewiesen, dass bei Verwendung der Flip-Chip-Montage (Fig.4,5) die nachfolgenden Schritte weitgehend analog zu den für die Wire-Bonding-Methode gezeigten Schritten erfolgen, mit dem Unterschied, dass auf ein Vergiessen hier verzichtet werden kann.

Der mechanisch und elektrisch montierte Halbleiterchip 8 wird anschliessend mit der Vergussmasse 11 vergossen (Fig.3E), wobei in diesem Fall auch der Substratrand 23 vollständig bedeckt werden kann, weil der elektrische Anschluss der IS über die Bumps 21 auf der Unterseite des Substrats 17 erfolgt.

Im vergossenen Zustand gemäss Fig.3E wird die IS vollständig dynamisch getestet (wobei die Prüfspitzen des Testers von der Unterseite des Substrats 17 her die Bumps 21 kontaktieren) und kann schliesslich mittels Flip-Chip-Montage auf der Schaltungsplatte 16 befestigt werden (Fig.3F; die auf der Schaltungsplatte 16 vorhandenen Leiterbahnen sind in der Figur nicht dargestellt).

Wie beide Ausführungsbeispiele zeigen, stehen mit der Erfindung hochintegrierte Schaltungen zur Verfügung, die sich einerseits vor der endgültigen Montage vollständig dynamisch und im Burn-in testen lassen, andererseits aber nicht wesentlich mehr Platz beanspruchen als der aktive Si-Chip.

**Ansprüche**

1. Hochintegrierte Schaltung, insbesondere für ein Multi-Chip-Modul, umfassend:
(a) einen flächigen Halbleiterchip (8) mit einer Chip-Fläche (F2) und einer Vielzahl von in einem ersten Rastermass angeordneten Chip-Anschlüssen (22);
(b) ein flächiges Substrat (17) mit einer Oberseite und einer Unterseite und einer Substratfläche (F1), welche grösser ist als die Chip-Fläche (F2);
(c) auf der Oberseite des Substrats (17) eine Montagefläche (2), auf welcher der Halbleiterchip (8) angeordnet ist; wobei
(d) das Substrat (17) auf allen Seite9n mit einem Substratrand (23) über den Halbleiterchip (8) hinausragt; und
(e) auf der Oberseite des Substrats (17) erste Anschlussflächen (19) vorgesehen sind mit einem Rastermass (d), welches im wesentlichen gleich dem ersten Rastermass ist; und
(f) die Chip-Anschlüsse (22) mit den ersten Anschlussflächen (19) leitend verbunden sind;
dadurch gekennzeichnet, dass
(g) der Substratrand (23) eine Randbreite (B) von nur wenigen Millimetern aufweist; und
(h) Anschlüsse zum Testen des Halbleiterchips (8) ausserhalb des Substratrands (23) vorgesehen sind.

2. Hochintegrierte Schaltung nach Anspruch 1, dadurch gekennzeichnet, dass die Randbreite (B) kleiner 2 mm ist.

3. Hochintegrierte Schaltung nach Anspruch 2, dadurch gekennzeichnet, dass

(a) auf der Oberseite des Substrats (17) Leiterbahnen (4) von den ersten Anschlussflächen (19) ausgehend zu den Rändern des Substrats (17) verlaufen; und

(b) an den Rändern des Substrats (17) zweite Anschlussflächen (19') vorgesehen sind, welche mit den ersten Anschlussflächen (19) durch die Leiterbahnen (4) verbunden sind.

4. Hochintegrierte Schaltung nach Anspruch 2, dadurch gekennzeichnet, dass

(a) innerhalb der Montagefläche (2) im Substrat (17) durchmetallisierte Durchkontaktierungs-Bohrungen (18) vorgesehen sind, welche die Oberseite des Substrats (17) mit seiner Unterseite leitend verbinden, und auf der Unterseite Kontaktflächen in Form von Bumps (21) aufweisen;

(b) die Durchkontaktierungs-Bohrungen (18) in einem Rastermass (e) angeordnet sind, welches wesentlich grösser ist als das erste Rastermass; und

(c) zumindest auf der Oberseite des Substrats (17) Leiterbehnen (20) von den ersten Anschlussflächen (19) ausgehend zu den Durchkontaktierungs-Bohrungen (18) verlaufen.

5. Hochintegrierte Schaltung nach einem der Ansprüche 3 und 4, dadurch gekennzeichnet, dass die ersten Anschlussflächen (19) mit den Chip-Anschlüssen (22) durch Anschlussdrähte (9) verbunden sind und der Halbleiterchip (8) mit einer Vergussmasse (11) abgedeckt ist.

6. Hochintegrierte Schaltung nach einem der Ansprüche 3 und 4, dadurch gekennzeichnet, dass die ersten Anschlussflächen (19) spiegelbildlich zu den Chip-Anschlüssen (22) angeordnet und mit diesen direkt verlötet sind.

7. Verfahren zur Herstellung einer hochintegrierten Schaltung nach Anspruch 3, gekennzeichnet durch folgende Schritte:

(a) auf eine Substratplatte (6), welche eine Fläche aufweist, die wesentlich grösser ist als die Substratfläche (F1), und welche das spätere Substrat (17) mit der Montagefläche (2) in der Flächenmitte liegend enthält, werden innerhalb der Substratfläche (F1) die ersten Anschlussflächen (19) und ausserhalb der Substratfläche (F1) mit einem wesentlich grösseren Rastermass (c) Testanschlüsse (5) aufgebracht, sowie Leiterbahnen (4) welche die ersten Anschlussflächen (19) mit den Testanschlüssen (5) verbinden;

(b) der Halbleiterchip (8) wird innerhalb der Montagefläche (2) auf der Substratplatte (6) befestigt;

(c) die Chip-Anschlüsse (22) werden mit den ersten Anschlussflächen (19) leitend verbunden;

(d) der Halbleiterchip (8) wird mittels der Testanschlüsse (5) in seiner Funktion vollständig durchgetestet; und

(e) das Substrat (17) wird von der Substratplatte (6) abgetrennt, wobei die Leiterbahnen (4) an den Rändern des Substrats (17) durchgetrennt werden.

8. Verfahren nach Anspruch 7, dadurch gekennzeichnet, dass

(a) eine Substratplatte (6) aus einer isolierenden Keramik oder aus Silizium mit einer Isolierschicht verwendet wird;

(b) die Durchkontaktierungs-Bohrungen (18) mit einem Laser hergestellt werden;

(c) die ersten Anschlussflächen (19), Leiterbahnen (4) und Testanschlüsse (5) durch chemische Abscheidung mehrerer Metallschichten, insbesondere aus Cu, Ni und Au, aufgebracht werden; und

(c) zum Abtrennen des Substrats (17) von der Substratplatte (6) diese entlang von Trennlinien (7) geritzt und anschliessend gebrochen wird.

9. Verfahren zur Herstellung einer hochintegrierten Schaltung nach Anspruch 4, gekennzeichnet durch die folgenden Schritte:

(a) in das Substrat (17) werden innerhalb der Montagefläche (2) die Durchkontaktierungs-Bohrung (18) eingebracht;

(b) auf das Substrat (17) werden die ersten Anschlussflächen (19) aufgebracht, sowie Leiterbahnen (20), welche die ersten Anschlussflächen (19) mit den Durchkontaktierungs-Bohrungen (18) verbinden;

(c) die Durchkontaktierungs-Bohrungen (18) werden durchmetallisiert und auf der Unterseite mit den Bumps (21) versehen;

(d) der Halbleiterchip (8) wird innerhalb der Montagefläche (2) auf dem Substrat (17) befestigt;

(e) die Chip-Anschlüsse (22) werden mit den ersten Anschlussflächen (19) leitend verbunden, und

(g) der Halbleiterchip (8) wird mittels der Bumps (21) in seiner Funktion vollständig durchgetestet.

10. Verfahren nach Anspruch 9, dadurch gekennzeichnet, dass

(a) ein Substrat (17) aus einer isolierenden Keramik oder aus Silizium mit einer Isolierschicht verwendet wird;

(b) die ersten Anschlussflächen (19), Leiterbahnen (20) und die Durchmetallisierung der Durchkontaktierungs-Bohrungen (18) durch chemische Abscheidung mehrerer Metallschichten, insbesondere aus Cu, Ni und Au, erzeugt werden; und

(c) die Bumps (21) elektrochemisch abgeschieden werden.

FIG.1

FIG.2A

FIG.3A

FIG.3B

FIG.3C

FIG.3D

FIG.3E

FIG.3F

88/073

FIG.2B

FIG.2C

FIG.2D

FIG.2E
(a)

(b)

FIG.2F

88/073

19,22    8    4    5

6

FIG.4

19,22    8

17

21

FIG.5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-2 094 552 (THOMSON) <br> * Figur 3; Ansprüche 1,5 * <br> --- | 1-3 | H 01 L 23/498 <br> H 01 L 21/66 |
| A | DE-A-2 938 567 (SIEMENS) <br> --- | | |
| A | US-A-4 701 781 (NATIONAL SEMICONDUCTOR) <br> --- | | |
| A | US-A-4 102 039 (MOTOROLA) <br> --- | | |
| A | US-A-4 566 184 (ROCKWELL) <br> * Figur 1; Anspruch 1 * <br> --- | 4,5 | |
| A | WO-A-8 704 316 (MOTOROLA) <br> * Figuren 2,4; Ansprüche 1,8 * <br> --- | 4,8-10 | |
| A | EP-A-0 120 500 (NEC) <br> --- | | |
| A | PATENT ABSTRACTS OF JAPAN, Band 5, Nr. 159 (E-77)[831], 14. Oktober 1981; & JP-A-56 88 343 (FUJITSU K.K.) 17-07-1981 <br> ----- | | |

RECHERCHIERTE
SACHGEBIETE (Int. Cl.4)

H 01 L

Der vorliegende Recherchenbericht wurde für alle Patentansprüche erstellt

| Recherchenort | Abschlußdatum der Recherche | Prüfer |
|---|---|---|
| DEN HAAG | 20-09-1989 | DE RAEVE R.A.L. |